Europäisches Patentamt

European Patent Office

Office européen des brevets

(11) Publication number: **0 083 237**
**B1**

## EUROPEAN PATENT SPECIFICATION

(45) Date of publication of patent specification: **25.05.88**

(21) Application number: **82306961.2**

(22) Date of filing: **24.12.82**

(51) Int. Cl.[4]: **H 03 H 9/17, H 03 H 9/58, H 03 H 9/56, H 03 H 9/05**

(54) **Ceramic resonator, and ceramic filter using the ceramic resonator.**

(30) Priority: **29.12.81 JP 213743/81**
**24.02.82 JP 28430/82**
**07.04.82 JP 57588/82**

(43) Date of publication of application:
**06.07.83 Bulletin 83/27**

(45) Publication of the grant of the patent:
**25.05.88 Bulletin 88/21**

(84) Designated Contracting States:
**DE FR GB NL**

(56) References cited:
**FR-A-2 235 532**
**US-A-3 610 969**
**US-A-4 356 421**

**PATENTS ABSTRACTS OF JAPAN, vol. 6, no. 12(E-91)(890), 23rd January 1982; & JP - A - 56 134 817 (HIROSHI SHIMIZU) 21-10-1981**

**PATENTS ABSTRACTS OF JAPAN, vol. 3, no. 47(E-105), 20th April 1979, page 137E105; & JP - A - 54 25192 (MATSUSHITA DENKI SANGYO K.K.) 24-02-1979 Idem**

(73) Proprietor: **FUJITSU LIMITED**
**1015, Kamikodanaka Nakahara-ku Kawasaki-shi Kanagawa 211 (JP)**

(72) Inventor: **Kasai, Yoshihiko c/o FUJITSU LIMITED**
**Patent Department 1015 Kamikodanaka Nakahara-ku Kawasaki-shi Kanagawa 211 (JP)**

(74) Representative: **Sunderland, James Harry et al HASELTINE LAKE & CO Hazlitt House 28 Southampton Buildings Chancery Lane London WC2A 1AT (GB)**

(56) References cited:
**PATENTS ABSTRACTS OF JAPAN, vol. 2, no. 65, 18th May 1978, page 2342E78; & JP - A - 53 33030 (NIPPON DENKI K.K.) 28-03-1978**

# Description

This invention relates to a ceramic resonator and a ceramic filter using the ceramic resonator.

A ceramic resonator using a piezoelectric ceramic material can provide many advantages such as small size, freedom from the need for adjustment, no coil etc., and therefore such resonators are widely used in intermediate frequency filters in radio communication equipment. Moreover, providing the highly desirable feature of good alignment with IC's and LSI's and in view of the great advances in performance of recent piezoelectric ceramic materials, such ceramic resonators will, it is anticipated, find much wider fields of application in the future.

Ceramic resonators in practical use fall into two types; one type utilising contour vibration such as radial mode vibration, and the other type, the so-called energy trapping type, utilising thickness-extensional vibration or thickness-shear vibration. However, difficulties are encountered in the fabrication of such ceramic resonators for use in the frequency range from several hundreds kHz to several MHz and such resonators are moreover large in size in that frequency range. This has delayed the realisation of practical such resonators.

New types of resonator, different from the conventional types, namely edge mode resonators, width-shear resonators, and width-extensional resonators, have generated a great deal of enthusiasm for their possible uses as ceramic resonators in the bandwidth from several hundreds kHz to several MHz.

A ceramic resonator using width-extensional vibrational of a rectangular shaped piezoelectric ceramic platelet can be manufactured very easily because the polarising (poling) direction and the AC field direction for activating vibration are identical. Moreover, since a small size energy trapping type resonator can be realised in the frequency range from several hundreds kHz to several MHz, such a resonator is well suited for use in that frequency band, operation in which band has conventionally been considered difficult to achieve.

Resonators utilising contour vibration, such as radial mode vibration, physically become smaller in size as their operating frequency ranges become higher, because the resonant frequency is inversely proportional to the dimension of the relevant contour, or to the diameter in the case of a disc shape. This makes manufacture difficult for higher frequencies and the practical frequency range for such resonators extends up to several hundred kHz only.

Moreover, a resonator utilising contour vibration vibrates over its entire extent and only at a node does vibration displacement become zero. However, the node is located at the centre of the disc shape in the case of radial mode vibration. The resonator must be supported at the node. If a supporting means at the node is made more rigid, leakage of energy to the outside occurs through the supporting means and therefore a comparatively soft supporting means is generally employed. As a result, reliability when external vibration is suffered is reduced.

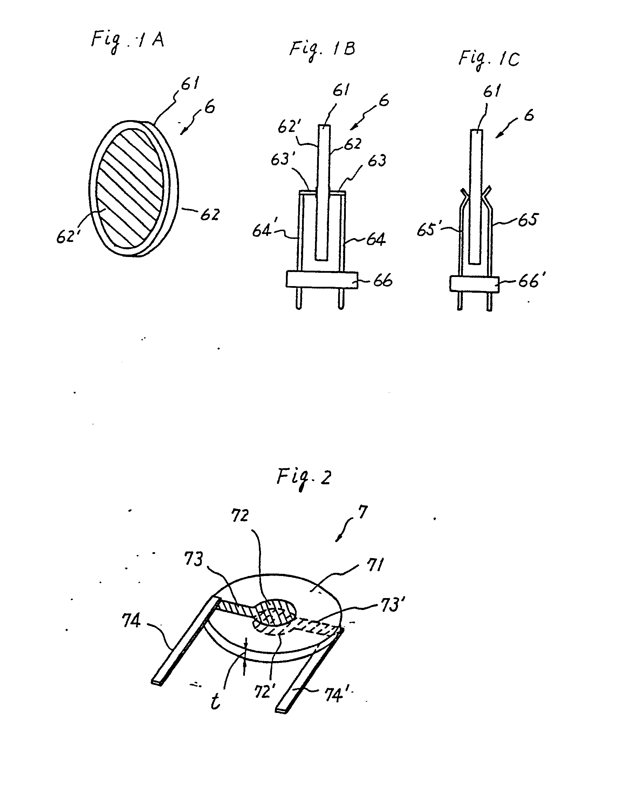

Fig. 1A of the accompayning drawings is a perspective view of a resonator 6 utilising the above-mentioned radial mode vibration. In Fig. 1A, thin film electrodes 62, 62' are formed by evaporation on the two opposite sides of a piezoelectric ceramic platelet 61. This resonator is supported in such a manner as is shown in Fig. 1B or 1C.

In Fig. 1B, ends of thin wires 63, 63', of which the other ends are fixed to metal supporting posts 64, 64' clamped to an insulation substrate 66, are settled with (fixed by) conductive adhesive to the centres of the metal thin films 62, 62' on the two sides of the piezoelectric ceramic platelet 61.

In Fig. 1C, metal supporting means 65, 65' fixed to an insulation substrate 66', are composed of elastic material and the supporting means 65, 65' are connected, at their end portions, to the centres of metal thin film electrodes 62, 62' on both sides of the piezoelectric ceramic platelet 61, to hold the resonator 6.

On the other hand, a resonator utilising thickness-extensional vibration or thickness-shear vibration of a piezoelectric ceramic platelet is capable of assuring high reliability when external vibration is suffered. This is because the resonant frequency is reversely (inversely) proportional to plate thickness and vibration energy is trapped at the centre of the plate and thereby the external edge of piezoelectric ceramic platelet can be held firmly. However, the external dimension of resonator must be set to a value 30 or more times the plate thickness in order to improve vibration energy trapping performance.

For example, a resonator of a frequency of 10 MHz has a thickness of about 0.13 mm and diameter of about 3 mm, but a resonator of a frequency of 1 to 2 MHz has a thickness of 0.7 to 1.3 mm and diameter of 20 to 30 mm, failing to provide the small size which is a desired feature of a ceramic resonator. For this reason, ceramic resonators of the energy trapping type have been put into practical use in the frequency range of several MHz or more.

Fig. 2 of the accompanying drawings is a perspective view of an example of the ceramic resonator 7 utilising thickness-extensional vibration, wherein metal thin film electrodes 72, 72' are formed by evaporation at the centres of both sides (main faces) of a piezoelectric ceramic platelet 71. The edge of the piezoelectric ceramic platelet 71 is held by conductive metal holders 74, 74', which are connected to the metal thin film electrodes 72, 72' via connecting belt electrodes 73, 73'. Thereby, a greater part of the vibration energy is trapped within the area sandwiched by the opposing metal thin film electrodes 72, 72'.

As explained above, a conventional ceramic resonator has a disadvantage in that it becomes physically too small for easy manufacture for the frequency range from several hundreds kHz to several MHz, or it becomes too large, mismatching LSI circuits etc. Moreover, a ceramic resonator of the contour vibration mode has not yet been put into practical use for a high frequency band because reliability of the supporting means is insufficient.

A usual piezoelectric ceramic material used for a ceramic resonator has a Poisson's ratio of 1/3 or less. Therefore, it is known that a ceramic resonator which consists of a rectangular piezoelectric ceramic platelet and shows thickness-extensional vibration functions as the backward-wave-mode energy trapping resonator. The relationship between the resonant frequency $f_0$ of extensional vibration and the size of such a ceramic resonator is expressed by equation (1).

$$f_0 = \{1/(2\ W_0)\} \cdot v\ [Hz] \qquad (1),$$

where $W_0$ is width of the resonator [m] and $v$ is extensional propagation velicity [m/s].

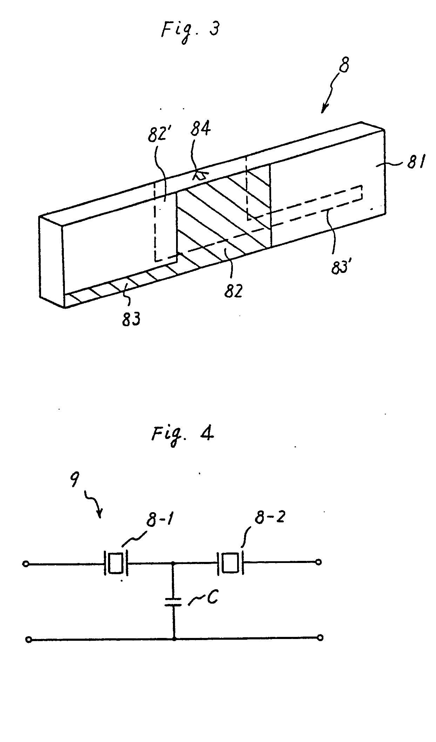

Fig. 3 of the accompanying drawings is a perspective view indicating a structure of a ceramic resonator utilising width-extensional vibration of such a piezoelectric ceramic platelet.

In Fig. 3, 81 is a piezoelectric ceramic platelet, with a pair of thin film electrodes 82, 82' attached by evaporation for example at the centres of the longitudinally extending faces of the platelet. This ceramic resonator is fixed at its edge in the longitudinal direction of piezoelectric ceramic platelet by holding means not indicated, and an AC electric field is applied in order to drive the ceramic resonator via said holding means. Therefore, the electrodes 82, 82' are respectively provided with strip electrodes 83, 83' which extend towards different edge ends, as shown in Fig. 3. The arrow mark 84 shows the poling direction.

When an AC electric field is applied across the electrodes 82, 82', width-extensional vibration is excited by the piezoelectrically unstiffened effect of a piezoelectric ceramic platelet. The ceramic resonator of Fig. 3 is an energy trapping type resonator based on the complex branches (Reference: US 78—63, March 28, 1978. The Institute of Electronics and Communication Engineers of Japan, Technical Group on Ultrasonics) and the width-extensional vibration is trapped within the piezoelectric ceramic platelet area to which the pair of opposing electrodes (82, 82') are attached.

A ceramic resonator of the width-extensional vibration mode can thus be realised.

Manufacture of such a ceramic resonator as is shown in Fig. 3 will now be explained.

First, the piezoelectric ceramic platelet 81 is finished to a specified size by grinding etc. and then thin film electrodes 82, 82' must partially be attached, for example by evaporation, respectively to the main surfaces, opposite in the thickness direction, as shown in Fig. 3. In order to obtain the partial electrodes, it is necessary to place a mask on the piezoelectric ceramic platelet 81 so that electrode material is not attached where it is not wanted. In this case, for example, the piezoelectric ceramic platelet 81 measures about 0.2 mm in thickness, about 0.9 mm in width and about 15 mm in length for a frequency of 2 MHz, and therefore it is very difficult to accurately place the mask in view of the size of those dimensions. Upon completion of attachment of the electrodes, poling 84 is carried out by applying a DC voltage across opposing electrodes, and thus a piezoelectric ceramic resonator 8 can be obtained. Moreover, this ceramic resonator must be subjected to adjustment of resonant frequency in order to obtain a desired characteristic.

Since the resonant frequency of width-extensional vibration is reversely (inversely) proportional to the width of the resonator, the width of piezoelectric ceramic platelet is reduced by grinding etc. for adjustment of the frequency. A ceramic resonator is usually required to have a frequency adjustment accuracy of 1 to $5 \times 10^{-4}$, and the frequency is thereby adjusted to an accuracy of 200 Hz to 1000 Hz for the above ceramic resonator. To obtain a grinding accuracy of 0.09 µm to 0.45 µm for the 2 MHz ceramic resonator above, which accuracy is required in the grinding of the width dimension, is very difficult with current grinding techniques.

As explained above, a width-extensional resonator as shown in Fig. 3 can provide a small size ceramic resonator for the frequency range of several hundreds kHz to several MHz, but it is not economical because a long time is required for manufacture and adjustment of the ceramic resonator needing grinding work to such a high accuracy.

A single ceramic resonator is discussed in the above explanation. A ceramic filter, combining plurality of ceramic resonators, will now be explained below.

Fig. 4 illustrates schematically a structural example of a ceramic filter 9. In Fig. 4, 8-1, 8-2 are ceramic resonators and C is a capacitor.

As an energy trapping ceramic resonator to be used for the ladder type ceramic filter 9 shown in Fig. 4, a thickness-extensional resonator and thickness-shear resonator, utilising the thickness vibration of a platelet, is mainly employed. For example, regarding a thickness-extensional ceramic resonator as shown in Fig. 2, (where thin film electrodes 72, 72' are attached by evaporation to opposite sides of piezoelectric ceramic platelet 71 with a thickness t; the peripheral edge of piezoelectric ceramic platelet 71 is held by a metal holding means 74, 74'; the thin film electrodes 72, 72' are connected to the strip electrodes 73, 73'; and a great deal of vibration energy is trapped within the area sandwiched between the thin film electrodes 72, 72') and regarding a thickness shear resonator, resonant frequency of such a ceramic resonator is determined by the plate thickness of the ceramic resonator as indicated by the equations (2) and (3).

$$f_n = K_E/t_1 \times n\ [Hz] \qquad (2)$$

$$f_m = K_s/t_2 \times m \text{ [Hz]} \qquad (3)$$

In these equations (2), (3), $f_n$ is the resonant frequency [Hz] of the thickness-extensional ceramic resonator, $f_m$ is the resonant frequency [Hz] of the thickness-shear ceramic resonator, $K_E$ is a constant [Hz m] determined in dependence upon the material of which the thickness-extensional ceramic resonator is made, $K_S$ is a constant [Hz m] determined in dependence upon the material of which the thickness-shear ceramic resonator is made, $t_1$ is the thickness [m] of the thickness extensional ceramic resonator, $t_2$ is the thickness [m] of the thickness-shear ceramic resonator, and $n$ and $m$ are degrees (1, 3, 5, ...) or vibrational mode orders.

Namely, the resonant frequency of a thickness-extensional ceramic resonator and of a thickness-shear resonator is reversely (inversely) proportional to the thickness of the plate.

In addition to such thickness-extensional ceramic resonators and thickness-shear ceramic resonators, the width-extensional resonator 8 as shown in Fig. 3 might also be considered as an energy trapping ceramic resonator 7 for use in a ladder type ceramic filter as shown in Fig. 4. The width-extensional resonator offers alleviation of restrictions on slection of the dimensional ratio of the piezoelectric ceramic platelet and selection of supporting means for the resonators.

However, existing ceramic filters have employed a thickness-extensional ceramic resonator or a thickness-shear ceramic resonator 2 as ceramic resonators 8-1 and 8-2 shown in Fig. 4.

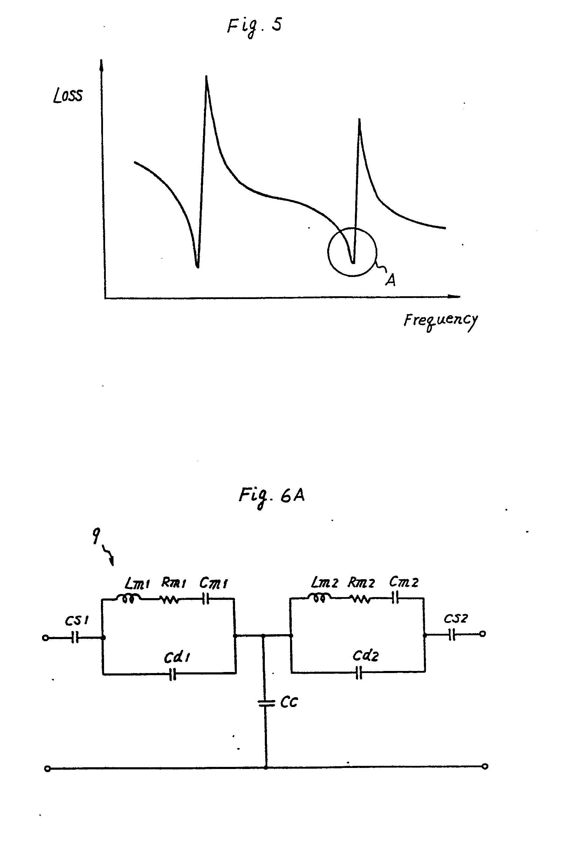

Such existing ceramic filters have disadvantages. An existing ceramic filter utilises as resonators 8-1 and 8-2 in Fig. 4 thickness-extensional ceramic resonators, or thickness-shear ceramic resonators, having the same plate thickness (width-extensional ceramic resonators of the same plate thickness might also be considered). Therefore, if the main vibration of a ceramic resonator (for example, the thickness-shear basic wave) is used, the resonant frequencies of the ceramic resonators become equal even in higher order modes (e.g. the 3rd or 5th modes of thickness-shear vibration), and a spurious response A appears in the attenuation band as shown in the graph of Fig. 5 of the accompanying drawings, causing deterioration of the out-band frequency loss characteristic. Namely, since an unwanted signal is not sufficiently lost (attenuated) in the attenuation band, the unwanted signal also exists, reducing the S/N ratio of the filter output signal and causing the performance of communication equipment to be degraded. As a result, an existing ceramic filter is required to provide a circuit for suppressing spurious response A in the attenuation band in the output stage of the ceramic filter of Fig. 4, resulting in a disadvantage in that the communication equipment becomes larger in size.

Such a ceramic filter having a structure combining a plurality of such ceramic resonators will be further explained from a different viewpoint.

Fig. 6A of the accompanying drawings is an equivalent circuit of the ceramic filter shown in Fig. 4.

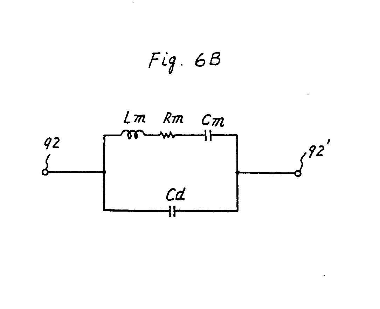

In this case, the equivalent circuit of a ceramic resonator can be as indicated in Fig. 6B of the accompanying drawings, in which Cd is, for example, damped capacitance of the piezoelectric ceramic platelet 81 of Fig. 3 as dielectric material, and the series circuit of Lm-Rm-Cm represents electrical energy and mechanical energy generated by vibration.

An equivalent circuit as shown in Fig. 6B can represent behaviour obtained through generation of width-extensional vibration by applying an AC electric field across the electrodes 82, 82'.

The configuration of a ceramic filter using such existing ceramic resonators is always accompanied with following disadvantages.

A ceramic filter is generally shown as having the equivalent circuit shown in Fig. 6A, but configuration of a ceramic filter indicated by the equivalent circuit shown in Fig. 6A using a ceramic resonator as shown in Fig. 3 requires three capacitors corresponding to $C_{s1}$, $C_{s2}$, $C_c$ in the equivalent circuit as shown in Fig. 6A, thus increasing the number of component elements and resulting in physical enlargement of the filter.

Moreover, a ceramic resonator as shown in Fig. 3 also provides the disadvantage that manufacturing and adjustment requires highly accurate grinding work, requiring a longer manufacturing time and increased cost. For this reason, if a ceramic filter is constructed using such a ceramic resonator, it becomes expensive.

JP—A—56 131 817 discloses a ceramic width-extensional mode resonator having a piezoelectric ceramic platelet which is poled in its thickness direction and on opposite main surfaces of which, separated by the thickness of the platelet, electrodes are formed. In a longitudinally central part of the platelet the electrodes are of narrowed width, not covering the opposite main surfaces of the platelet corresponding to that central part.

According to the present invention there is provided a ceramic width-extensional mode resonator having a piezoelectric ceramic platelet with thickness direction poling, on opposite main surfaces of which platelet, separated by the thickness of the platelet, electrodes are formed, characterised in that the platelet has a portion, intermediate its opposite longitudinal ends, of a width narrower than the width at those opposite longitudinal ends, the opposite main surface parts of the platelet corresonding to the narrower width portion being entirely covered by electrodes.

Embodiments of the present invention can provide an energy trapping ceramic resonator wherein mechanical vibration energy is concentrated in a part of a piezoelectric ceramic resonator, and a ceramic filter using such a resonator.

An embodiment of the present invention can provide a highly reliable energy trapping ceramic resonator which operates in the frequency range from several hundreds kHz to several MHz.

An embodiment of the present invention can provide an economical and high performance ceramic resonator which is small in size for the frequency band from several hundreds kHz to several MHz and which offers easy manufacture and adjustment.

An embodiment of the present invention can provide a high performance ceramic filter not suffering the conventional disadvantages which offers suppression of out-band frequency response, which has been difficult with previous ladder type ceramic filter designs, without the need for a circuit for suppressing spurious response in the attenuation band. A ceramic filter can be provided using a lesser number of circuit elements which is very economical.

Briefly, in a ceramic resonator embodying the present invention the width of a central part (in the longitudinal direction) of a piezoelectric ceramic platelet is less than the width at both ends, and poling in the thickness direction is effected at least in the narrow width portion. That is, width in a part intermediate the ends of the pizeoelectric ceramic platelet is less than width at those ends. Metal thin film electrodes formed respectively over the two main surfaces of the piezoelectric ceramic platelet are each divided, to form first and third electrodes, separated from one another, on one main surface and to form second and fourth electrodes, separated from one another, on the other main surface. The first and second electrodes overlap in the width direction of the platelet across the narrow, decreased width region of the platelet, so that the decreased width region is sandwiched between the overlapping parts of the first and second electrodes, other parts of which electrodes extend in opposite longitudinal directions of the platelet on its main surfaces. A constant vibration based on the narrow width region is generated at the narrow width part when an electrical signal is applied to the electrodes.

The narrow width region of the ceramic resonator may be formed as a dent part formed in any one of the width directions. That is, the narrow width region is formed by indenting the platelet at either of the sides thereof separated by the width dimension of the platelet.

Alternatively, the narrow region may be formed as dents formed on both sides of the platelet separated in the width direction.

In addition, poling in the thickness direction may be effected over the entire length of the piezoelectric platelet.

Poling in the thickness direction may be carried out only in the narrowed part of the piezoelectric ceramic platelet.

The first electrode and the third electrode, and the second electrode and the fourth electrode, are respectively terminated by at least a connection to one of them.

The ceramic resonator may have dumping material provided at a width direction edge surface of the piezoelectric ceramic platelet to suppress spurious effects.

A ceramic filter embodying this invention can be formed in which a plurality of such ceramic resonators are connected in series. The ceramic resonators may feature a plurality of selected alternatives from those mentioned above.

In such a ceramic filter, the thickness of at least one of the plurality of ceramic resonators may be substantially different from the thickness of the other resonators.

Moreover, a series connecting part may be a capacitive connecting part connected in parallel.

Further, a ceramic filter embodying the present invention can provide a structure in which two resonators of the said plurality of ceramic resonators are considered respectively as first and second resonators, the first and fourth electrodes of said first and second resonators respectively being connected, the said connected fourth electrode connecting part being considered as a common end, one third electrode as an input end, and the other third electrode as an output end.

Reference is made, by way of example, to the accompanying drawings, in which:—

Fig. 1A is a perspective view of a previously proposed radial vibration mode resonator in which holding means are not shown, and Figs. 1B and 1C are side views of the resonator showing alternative possible holding means,

Fig. 2 is a perspective view of a previously proposed resonator utilising thickness-extensional vibration,

Fig. 3 is a perspective view of a previously proposed ceramic resonator utilising width-extensional vibration,

Fig. 4 schematically illustrates an example of the configuration of a ceramic filter comprising a plurality of ceramic resonators,

Fig. 5 is a graph illustrating a frequency vs. loss characteristic of a previously proposed ceramic filter,

Fig. 6A is an equivalent circuit diagram of a ceramic filter and Fig. 6B an equivalent circuit diagram of a ceramic resonator,

Fig. 7 shows a perspective view illustrating an embodiment of the present invention,

Fig. 8 is a plan view of the embodiment of Fig. 7,

Fig. 9, Fig. 10 and Fig. 13 are perspective views of respective further embodiments of the present invention,

Fig. 11 and Fig. 12 are graphs of frequency vs. voltage showing frequency response curves,

Fig. 14A is a plan view of a further embodiment of the present invention, and Fig. 14B is an equivalent circuit diagram thereof,

Fig. 15 is a schematic plan view of a ceramic filter in which two ceramic resonators embodying the present invention are connected,

Fig. 16 is a graph illustrating plate thickness vs. resonant frequency characteristic curves of a width-extensional ceramic resonator and a thickness-extensional ceramic resonator,

Fig. 17 is a graph illustrating a frequency vs. loss characteristic of a width-extensional ceramic resonator,

Fig. 18 is a graph illustrating frequency vs. loss characteristic of a ceramic filter embodying this invention,

Fig. 19 is a graph illustrating a frequency vs. loss characterstic of another ceramic filter embodying this invention,

Fig. 20A is a schematic plan view of a ceramic resonator for use in a different ceramic filter embodying the present invention, whilst Fig. 20B is an equivalent circuit diagram thereof, and

Fig. 21A is a schematic perspective view illustrating a ceramic filter connecting structure, whilst Fig. 21B is an equivalent circuit diagram thereof.

In the figures, 1, 1-1 to 1-8, 2, 6; 7, 8, 8-1, 8-2 are ceramic resonators; 3, 4, 9 are ceramic filters each using a plurality of ceramic resonators; 10, 20, 61, 71, 81 are piezoelectric ceramic platelets; 11a to 11d, 21a, 21b, 62, 62′ 71 to 73′, 82, 82′ are electrodes; 12a, 12b, 12ad, 12bb, 12bc, 42 are terminals; 13a, 13b, 23b are separators; 14, 14′ 24′ are arrow marks indicating polarising (poling) direction; 15, 25, 66, 66′ are insulating substrates; 16a, 16b, 26a, 26b are conductive adhesives; 17a, 17b 27a, 27b are supporters; 18a, 18b are dumping materials; 41 is a connecting line.

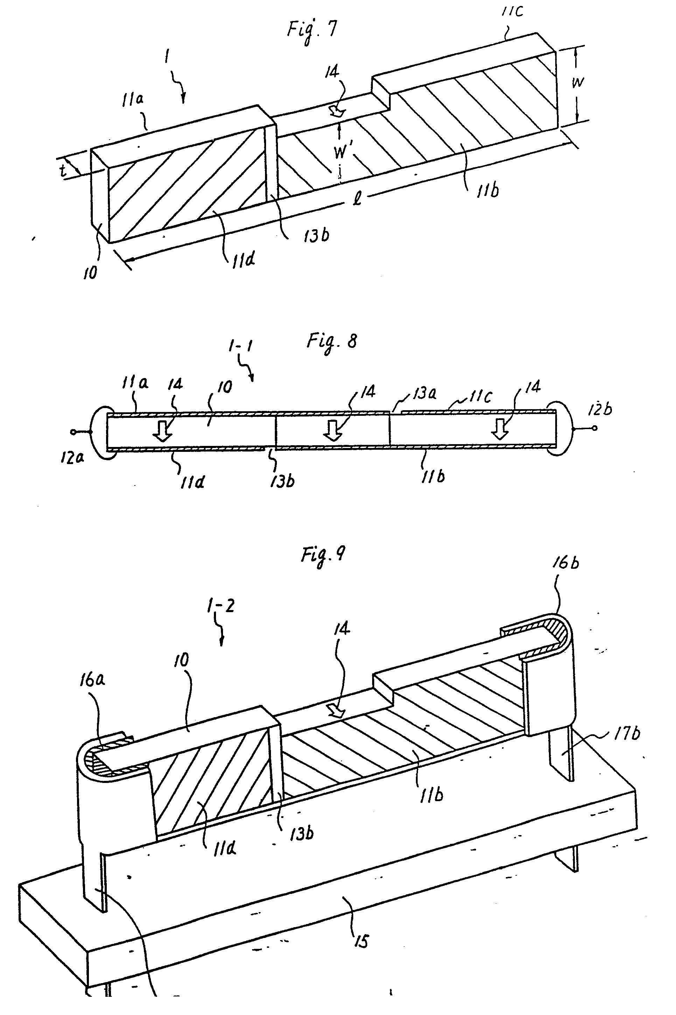

Fig. 7 and Fig. 8 are respectively a perspective view and plan view of a ceramic resonator 1 (1-1 in Fig. 8) embodying the present invention. Particularly, Fig. 7 shows a basic outline view.

The piezoelectric ceramic platelet 10 of the ceramic resonator 1 (1-1 in Fig. 8) measures $t$ in thickness, I in length and W in width, with a dent (indented) portion at its centre so that its width W′ at its centre is narrower than its width at its two ends. That is, intermediate the two ends of the platelet 10 a decreased width portion is formed by virtue of the presence of an indentation in the platelet. 11a to 11d are metal thin film electrodes formed on the two main surfaces of the platelet by evaporation. 12a, 12b are terminals; 13a, 13b are separator-regions from which metal thin film is removed. 14 is an arrow mark indicating the poling direction. The narrow (decreased width) part of piezoelectric ceramic platelet 10 is sandwiched between parts of the electrodes 11a, 11b. When a voltage is applied to the terminals 12a, 12b, the potential of electrodes 11a, 11d and electrodes 11b, 11c become equal but an electric field is applied to the decreased width part between the electrodes 11a and 11b. Electrode 11a will be called the first electrode. 11b the second electrode, 11c the third electrode, and 11d the fourth electrode, respectively.

The piezoelectric ceramic material used for a ceramic resonator has generally a Poisson's ratio of 1/3 or less and this means that the ceramic resonator is a backward-wave-mode trapping resonator as in the case of the equation (1).

Since the width W′ of the central region of the platelet is narrower than the width W at its two ends, it will be understood from equation (1) that the resonant frequency $f_1$ of width-extensional vibration at the central region is higher than the resonant frequency $f_2$ of width-extensional vibration at the two ends. Moreover, since the opposing first and fourth electrodes 11a and 11d, and the opposing second electrode and third electrodes 11b and 11c are terminated at the two opposite ends of the platelet, the elastic constant becomes small by the piezoelectric reaction and thereby the extensional propagation velocity $v$ becomes low and the resonant frequency $f_2$ at both ends further becomes low. Therefore, when an AC voltage is applied to the terminals 12a, 12b, an AC electric field is also applied to the decreased width central region and width-extensional vibration is generated by the piezoelectrically unstiffened effect.

Since the resonant frequency at the two ends is lower than that of the vibration excited in the decreased width narrow area, a propagation constant can be indicated by an imaginary number and vibration propagated to the two ends is attenuated. As a result, vibration energy excited by the AC electric field applied is concentrated in the decreased-width narrow area at the centre and thereby a so-called energy trapping resonator is obtained.

As explained above, since vibration energy is concentrated in the central decreased width area, vibration displacement at the two ends becomes zero, making possible to hold the resonator at its end portions. Thereby reliability when external vibration is suffered can be increased.

As a practical example, when a resonator of frequency 2 MHz is provided, the following data can be obtained, namely t=0.1 to 0.3 mm, I=7 to 13 mm, W≈1 mm, W′≈0.9 mm. With such dimensions, a resonator can be manufactured easily.

In addition, since the width W′ of the narrow or decreased width area, formed in order to obtain the desired resonant frequency, can be set easily to the desired value by forming a dent or indentation by means of the grinding etc., resonators dealing with frequencies from several hundreds kHz to several MHz can be manufactured very easily. Since simultaneous manufacture of plurality of piezoelectric ceramic platelets 10 is also easy, manufacturing cost can be reduced.

Fig. 9 is a perspective view of a practical structure of a ceramic resonator embodying the present invention. The same reference numbers as are used in Fig. 7 and Fig. 8 indicate the same features, and 15 is an insulating substrate; 16a and 16b are conductive adhesives; 17a and 17b are supporting means consisting of conductive metal materials. The supporting means 17a, 17b are fixed to the insulating substrate 15. The end portion of each supporting means is curved like a letter U, to hold the piezoelectric ceramic platelet 10 through the conductive adhesive 16a, 16b and to connect with the first to fourth electrodes 11a

to 11d, forming terminals 12a and 12b shown in Fig. 8.

The vibration displacement at the two ends of the resonator becomes zero, allowing rigid holding thereof and the opposing terminals are terminated through the U-shaped portions. Supporting means structures other than those shown in Fig. 9 can of course be used.

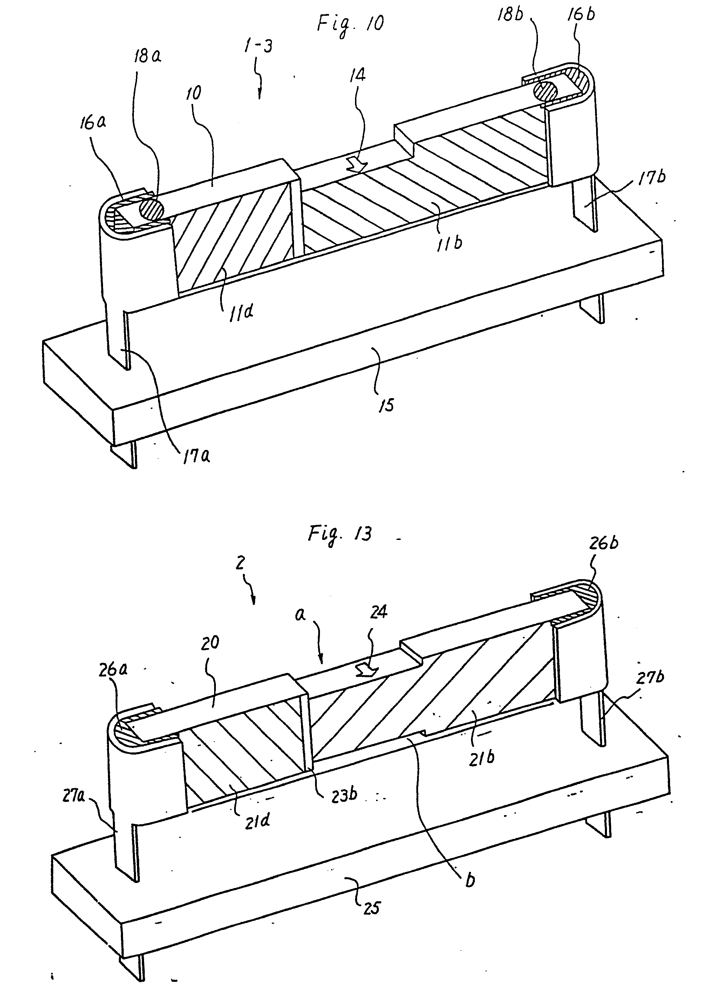

Fig. 10 is a perspective view of another embodiment of the present invention. The same reference numbers as those in Fig. 9 indicate the same features and 18a and 18b are dumping material. As explained with regard to the embodiment of Fig. 9, an AC electric field applied to the narrow or decreased width area causes width-extensional vibration. In this case, a piezoelectric ceramic platelet 10 can also generate vibration, by the piezoelectrically unstiffened effect, in the longitudinal direction and this vibration can further cause width flexure vibration depending on the conditions of the two ends, and thereby spurious effects can be generated at a frequency near the resonant frequency of extensional vibration in the width direction which is the main vibration.

The graph of Fig. 11 shows the frequency response of the embodiment of Fig. 9 in a case in which such spurious effects occur. In this graph, A and B show the spurious effects caused by the above-mentioned flexure vibration.

The dumping materials 18a, 18b in Fig. 10 are provided in order to suppress such spurious effects, suppressing flexure vibration without affecting the width-extension vibration of the main vibration.

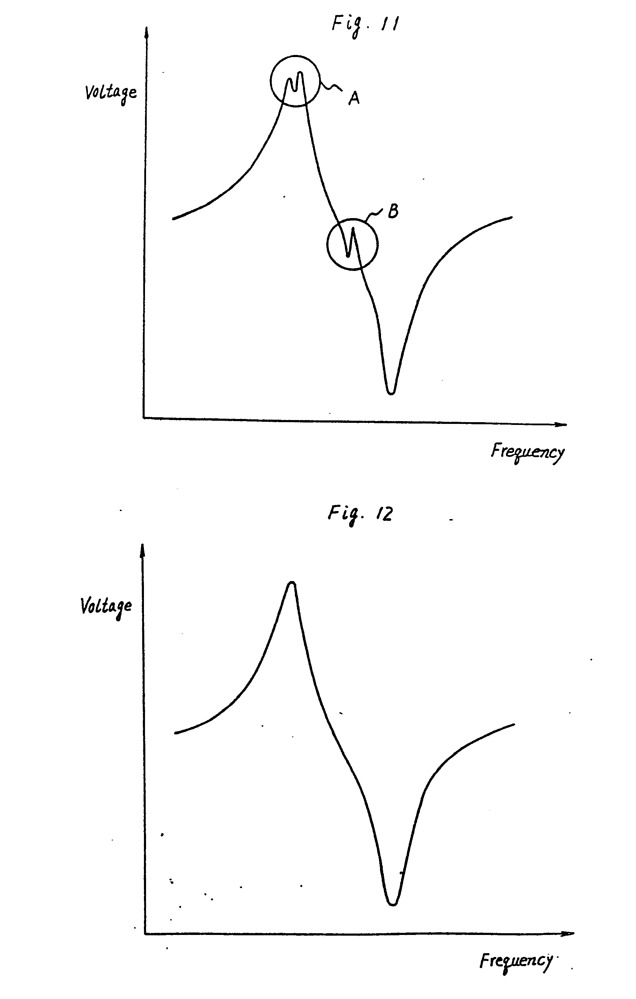

The graph of Fig. 12 shows frequency response of the embodiment of Fig. 10 provided with the dumping materials 18a, 18b. In this graph, the spurious effects A, B apparent in Fig. 11 do not appear at all.

As dumping material 18a, 18b, material showing large acoustic loss, for example, a resin of the epoxy system can be used. The dumping material can be used not only at the upper parts of the two ends of the piezoelectric ceramic platelet 10 but also at the lower part thereof. Thereby, a further improved supression of flexure vibration can be obtained.

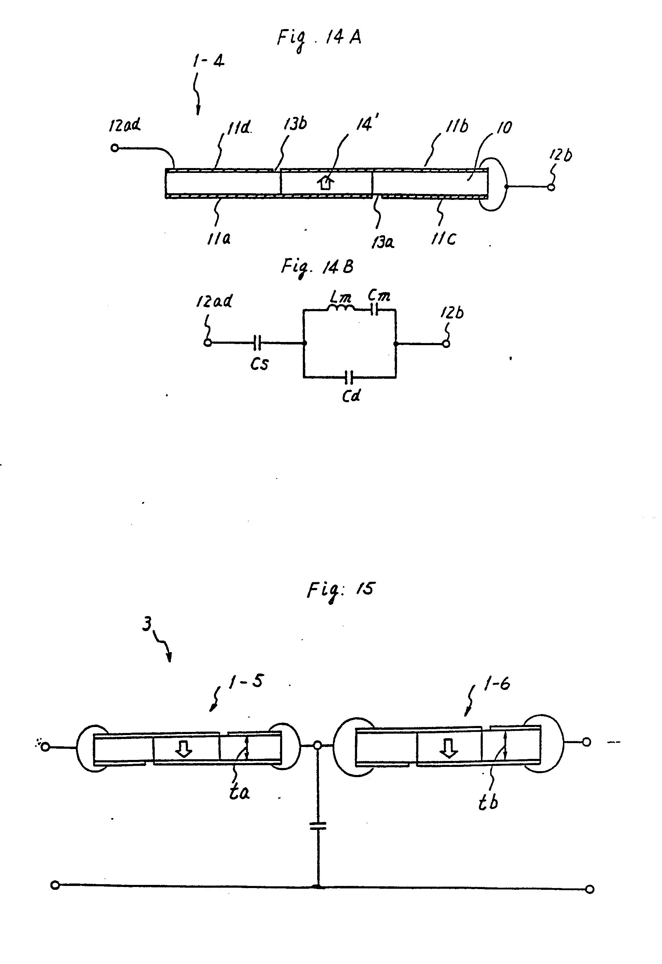

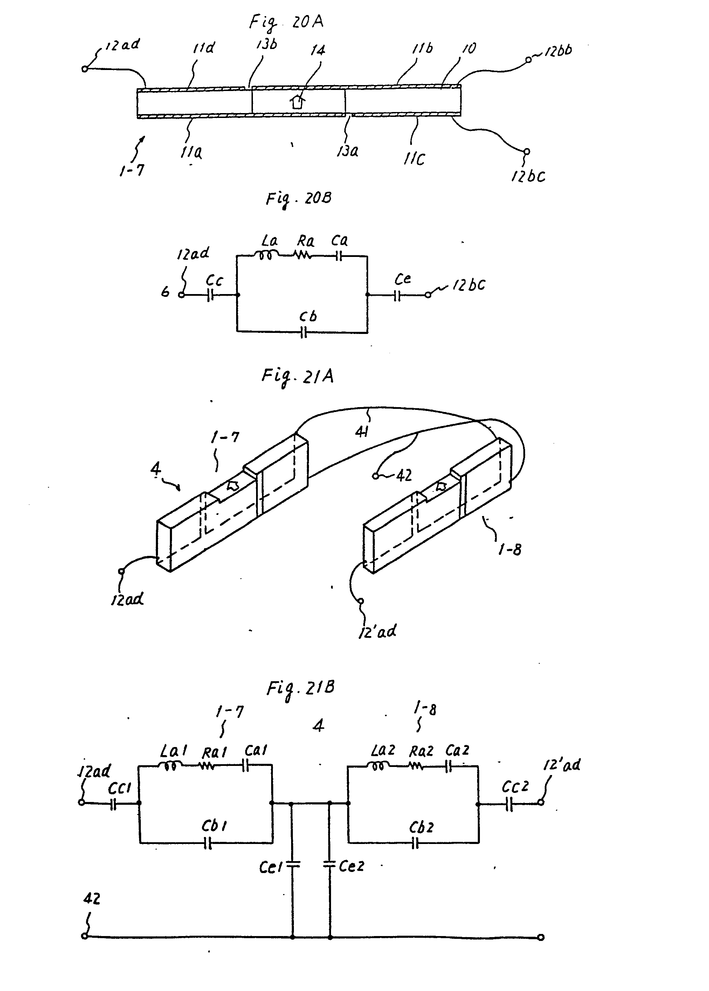

Fig. 13 is a perspective view of further embodiment of the present invention. In Fig. 13, 20 is a piezoelectric ceramic platelet; 21b and 21d are second and fourth electrodes; 23b is a separator; 24 is an arrow mark indicating the poling direction; 25 is an insulating substrate; 26a and 26b are conductive adhesives; 27a and 27b are metal supporting means.

The piezoelectric ceramic platelet 20 is provided with the dent (indented) areas a and b at its upper and lower surfaces, forming a narrow or decreased width area at the central part of platelet. The second and fourth electrodes 21b, 21d correspond to the second and fourth electrodes 11b, 11d of the embodiment of Figs. 7 and 8, and electrodes corresponding to the first and third electrodes 11a, 11d of Figs. 7 and 8 are provided at the opposite side of the platelet 20 but not shown in Fig. 13.

Formation of the dents or indentations a and b allows only pure vibration in the longitudinal direction, without generation of flexure vibration, because the piezoelectric ceramic platelet 20 has a symmetrical structure. As a result, spurious response effects resulting from flexure vibration disappear from the neighbourhood of the width-extensional vibration frequency of the main vibration and a frequency response which is almost the same as that shown in Fig. 12 can be obtained. Here, it is also possible to suppress any remaining flexure vibration component resulting from error in formation of the dents a and b, by providing dumping material as in the embodiment shown in Fig. 10.

A ceramic resonator in accordance with embodiments of this invention as described above comprises a piezoelectric ceramic platelet which is polarised (poled) as a whole in the thickness direction and has a narrow or decreased width area, at central region in the longitudinal direction (at a region intermediate the longitudinal ends of the platelet), of which the width W' is less than the width W at the two ends. First to fourth electrodes are provided which can be obtained by separating metal thin films formed by evaporation respectively on one side and on the other side of the piezoelectric ceramic platelet by separators, in such a manner as to sandwich the said narrow or decreased width area at different positions in the longitudinal direction; and respective terminals are provided which mutually connect the opposing first and fourth electrodes and the opposing second and third electrodes 11b, 11c at the two longitudinal direction ends of the platelet. When an AC electric field is applied across the terminals it is also applied to the narrow or decreased width area, causing therein width-extensional vibration; the extensional vibration generated at the central decreased width area is attenuated at both ends even when it is propagated thereto and thereby such ceramic platelet can be supported firmly at its end by such terminals.

Fig. 14A and Fig. 14B show a different ceramic resonator 1-4 embodying this invention. Fig. 14A is a top or plan view similar to that of Fig. 8, whilst Fig. 14B is equivalent circuit diagram.

In Figs. 14A and 14B, 10 is a piezoelectric ceramic platelet having a structure comprising a, so to call it, level-different narrowed area; a central area where width is narrower than at the two longitudinal ends of the platelet. 11a to 11d are thin film first to fourth electrodes attached to the main surfaces of the piezoelectric ceramic platelet in the thickness direction. The first electrode 11a and the third electrode 11c are separated (13a) at one longitudinal end of the level-different narrowed area and moreover, the second electrode 11b and the fourth electrode 11d are also separated (13b) at the other longitudinal end of the level-different narrowed area. The second electrode 11b and the third electrode 11c are connected at one end via holding means not illustrated which is also used as an external lead 12b.

The fourth electrode 11d is also connected to holding means not illustrated used as another external lead 12ad.

In this case, the first electrode 11a is not connected to any holding means.

If the holding means connecting the fourth electrode 11d is likely to contact the first electrode 11a, the first electrode 11a near those holding means may partly be removed.

14' shows the poling direction and the poling 14' is carried out only in the level-different narrowed area in the central region.

Operation of the ceramic resonator 1—4 of Figs. 14A and 14B will be explained below.

When an AC electric field is applied across the terminals 12ad, 12b, an electric field is applied to the level-different narrowed area via the fourth electrode 11d and the first electrode 11a and width-extensional vibration is gnerated by the piezoelectric effect at the narrow width reduced area in the central part of the platelet where poling 14' has been carried out.

Since the poling is not effected for the piezoelectric ceramic platelet 10 between the first electrode 11a and the fourth electrode 11d, this part of the piezoelectric ceramic platelet functions only as a dielectric. Therefore, the part between 11a and 11d operates only as a capacitance.

The capacitance Cs shown in the equivalent circuit of Fig. 14B corresponds to the capacitance effective between the first and fourth electrodes 11a, 11d.

Steps for manufacturing such a ceramic resonator embodying this invention will be explained hereunder.

After grinding a piezoelectric ceramic platelet to the desired thickness for the ceramic resonator, thin film electrodes are deposited by evaporation over the entireties of the main surfaces separated in the thickness direction, thereby completing a piezoelectric ceramic platelet wafer. Thereafter, a ceramic chip is formed by cutting the ceramic resonator to the desired width and length from such a wafer, and a plurality of such chips are layered, followed by the process for narrowing or decreasing the width of the central regions (in the longitudinal direction) of the chips, as shown in Fig. 7 or Fig. 13, thus to complete a ceramic resonator.

In a ceramic resonator of this condition, where electrodes are attached to the entireties of the main surfaces, electrodes are divided using a laser, for example, at the level-different narrowed area as shown in Fig. 7, Fig. 8 and Fig. 13, forming separators 13a, 13b, 23a, 23b. In addition, poling is carried out by applying a high DC voltage across the first and second electrodes 11a, 11b as shown in Fig. 14A.

As explained above, a ceramic resonator embodying this invention can be formed using a mass-production process involving batch processing, thereby to improve manufacturing efficiency and economy.

Moreover, the frequency of a ceramic resonator embodying this invention can be adjusted by grinding the width of ceramic resonator as in the case of the existing resonator, and also be changing Cs in the equivalent circuit shown in Fig. 14B.

Namely, in the equivalent circuit of Fig. 14B, resonant frequency $f$ is expressed by the following equation:—

$$f = \frac{1}{2\pi} \sqrt{\frac{1}{Lm \times \cfrac{1}{\cfrac{1}{Cm} + \cfrac{1}{Cd(1+a)}}}},$$

where $a = Cs/Cd$.

The value of Cs can also be changed by trimming the fourth electrode 11d, or the first electrode 11a which opposes the fourth electrode 11d.

As mentioned above, frequency of a ceramic resonator embodying this invention can be adjusted by grinding the width of ceramic resonator or by changing a value of Cs. Therefore, if a large amount of adjustment is necessary, both means of adjustment can be combined. Namely, at first grinding may be carried out using a machine such as a grinder and then a value of Cs can be adjusted for high precision adjustment. Consequently, high speed and high accuracy adjustment can be realised very easily, with resulting economy in production of the ceramic resonator.

Trimming of the electrode 11a or 11d can be carried out easily and accurately by irradiation with a laser beam for industrial use, but it can alternatively be carried out, of course, by other adequate means.

A ceramic filter embodying the present invention, using a combination of a plurality of ceramic resonators, will be explained below.

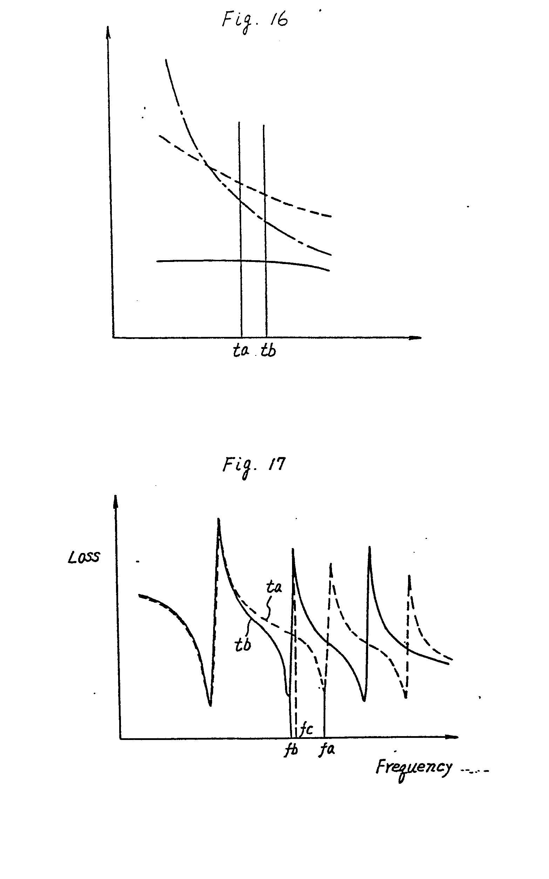

Fig. 15 illustrates such a ceramic filter, in which a pair of ceramic resonators 1-5, 1-6 are connected in series with the thickness of the piezoelectric ceramic platelets of the respective resonators being $t_a$ and $t_b$. With reference to Fig. 15, a ceramic filter embodying this invention will be further explained referring also to the graphs of Fig. 16 to Fig. 19.

The graph of Fig. 16 shows thickness vs. resonant frequency characteristics of a width-extensional ceramic resonator. In this graph, the horizontal axis indicates thickness of the ceramic resonator, the vertical axis indicates resonant frequency of the ceramic resonator, the solid curved line indicates the basic wave characteristic of width-extensional vibration, the broken line indicates the 3rd order mode characteristic of width-extensional vibration and the chain line indicates the basic wave characteristic of thickness-extensional vibration.

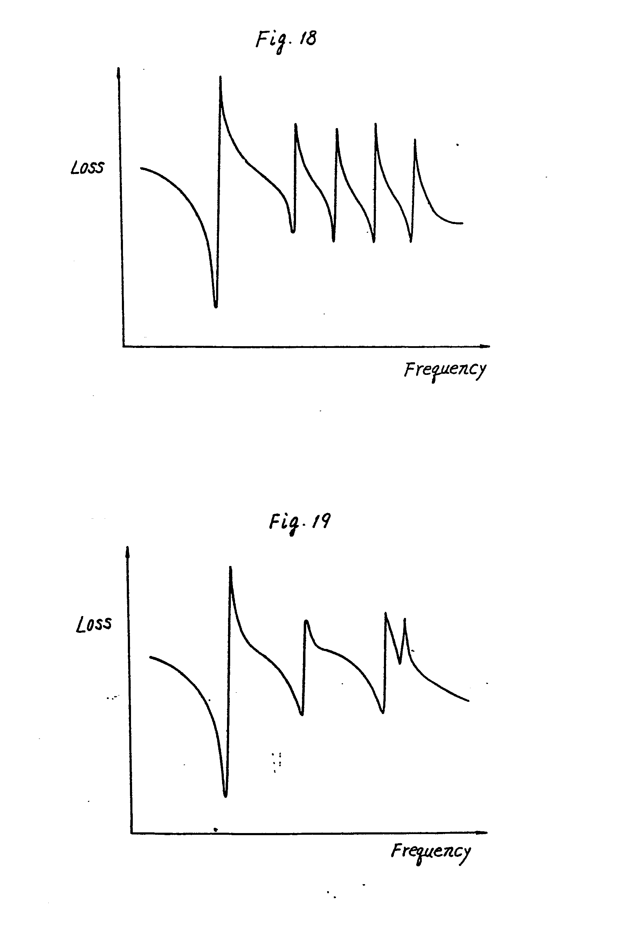

The graph of Fig. 17 shows frequency vs. loss characteristics of a width-extensional ceramic resonator. In this graph, the horizontal axis indicates frequency, the vertical axis indicates loss, the broken line indicates a characteristic of a width-extensional ceramic resonator of thickness $t_a$ and the solid line indicates a characteristic of a width-extensional ceramic resonator of thickness $t_b$.

The graph of Fig. 18 shows a frequency vs. loss characteristic of a ceramic filter embodying this invention. In this graph, the horizontal axis indicates frequency, whilst the vertical axis indicates loss.

The graph of Fig. 19 shows a frequency vs. loss cahracteristic of another ceramic filter embodying this invention. In this graph, the horizontal axis indicates frequency while the vertical axis indicates loss.

A ceramic filter embodying this invention uses a pair of width-extensional ceramic resonators of different thicknesses, as shown in Fig. 15. Namely, as a ceramic filter 3 of a ladder configuration, ceramic resonators 1-5, 1-6 with respective different thicknesses are used.

Width-extensional ceramic resonators have a characteristic in which resonant frequency changes as shown in the graph of Fig. 16 when resonator width is kept constant and resonator thickness is gradually changed. Namely, the resonant frequency of the fundamental wave of width-extensional vibration of a width-extensional ceramic resonator shows a little change as thickness changes because it is almost entirely determined by the width, the shape ratio determined by the width (W in Fig. 7) of the resonator and the thickness (t in Fig. 7) of the resonator having little influence. However, the 3rd order mode of width-extensional vibration is influenced by the shape ratio and the resonant frequency of thickness-extensional vibration in this mode is reversely (inversely) proportional to thickness. Consequently, as thickness of the resonator (t in Fig. 7) changes, the resonant frequency changes significantly.

For example, in a comparison between a width-extensional ceramic resonator having a thickness $t_a$ and a width-extensional ceramic resonator having a thickness $t_b$, as shown in the graph of Fig. 17, the resonant frequencies are almost equal for the main vibration (fundamental mode of width-extensional vibration), but resonant frequencies for the 3rd mode are $f_a$ for the width-extensional ceramic resonator of thickness $t_a$ and $f_b$ for the width-extensional ceramic resonator of thickness $t_b$.

Further, in the fifth order mode or in higher order modes, resonant frequencies also differ. As explained, resonant frequencies of vibrations other than the main vibration differ significantly for width-extensional ceramic resonators of different thicknesses $t_a$ and $t_b$.

When width-extensional ceramic resonators of thicknesses $t_a$ and $t_b$ are used respectively as ceramic resonators 1-5, 1-6 in the ladder type ceramic filter shown in Fig. 15, a frequency vs. loss characteristic for the ceramic filter as shown in the graph of Fig. 18 can be obtained. Namely, when width-extensional ceramic resonators of different thicknesses are used for a ladder type ceramic filter, a large out-band loss can be obtained, since the resonant frequencies of vibrations other than the main vibration of each width-extensional ceramic resonator are different, and as a result, out-band spurious responses can be made small.

Thus, a ceramic filter embdying this invention suppresses out-band spurious responses by using width-extensional ceramic resonators of different thicknesses in a ladder type circuit as shown in Fig. 4.

There has been explained above a ceramic filter of the ladder type as shown in Fig. 15 in which a pair of width-extensional ceramic resonators of different thicknesses are used. However, a ladder type ceramic filter using two or more width-extensional ceramic resonators can also suppress out-band spurious responses. In this case, the relationship between thicknesses of the width-extensional ceramic resonators is as follows:— it is necessary to provide a different thickness for at least one width-extensional ceramic resonator, among the plurality of width-extensional ceramic resonators making up the filter.

When the frequency $f_c$ of a width-extensional ceramic resonator having a thickness of $t_a$ (see Fig. 17) is matched to the frequency $f_a$ of a width-extensional ceramic resonator having a thickness $t_b$, by controlling the thicknesses $t_a$, $t_b$ of the width-extensional ceramic resonators, deterioration of frequency vs. loss characteristic due to resonance of the width-extensional ceramic resonator having thickness $t_b$ is suppressed by antiresonance of the width-extensional ceramic resonator having the thickness $t_a$. Thereby, a ceramic filter having a frequency vs. loss characteristic as shown in the graph of Fig. 19 can be obtained. Namely, as shown in Fig. 19 outband spurious responses are effectively suppressed and the frequency vs. loss characteristic can be improved more effectively by matching the resonant frequencies of the 3rd order mode of the width-extensional ceramic resonator having the thickness $t_b$ to the antiresonance frequency of the 3rd order mode of width-extensional ceramic resonator having the thickness $t_a$.

Thus, when a ladder type ceramic filter uses a plurality of width-extensional ceramic resonators having different thicknesses and a desired relationship between the thicknesses of each width-extensional ceramic resonator is established (namely when the resonant frequency of 3rd order mode of a certain width-extensional ceramic resonator matches the antiresonant frequency of the 3rd mode of other width-extensional ceramic resonators), the frequency vs. loss characteristics can be further improved.

Another ceramic filter comprising plurality of ceramic resonators and embodying the present invention will be explained hereunder with reference to Figs. 20A to 21B.

Fig. 20A is a plan view of a ceramic resonator used in the ceramic filter embodying the invention, whilst Fig. 20B is an equivalent circuit diagram of the ceramic resonator.

In Fig. 20A and 20B, 11a to 11d are first to fourth electrodes; 14 is the poling direction; 10 is a piezoelectric ceramic platelet; 13a and 13b are separators; 12ad is a connecting terminal of the fourth electrode 11d; 12bb is a connecting terminal of the second electrode 11b; 12bc is a connecting terminal of the third electrode 11c.

Fig. 21A is a perspective view of the ceramic filter and Fig. 21B is an equivalent circuit diagram of said ceramic filter. In these figures, 1-7 and 1-8 are ceramic resonators. These resonators have each suffered poling only in the narrow or width-decreased central region thereof.

When an AC electric field is applied across the terminals 12ad and 12bc of the ceramic resonator 1-7 (see Fig. 20A), an electric field is applied to the level-different narrow area (the width decreased region) via the electrodes 11a and 11b and width-extensional vibration is generated by the piezoelectrically unstiffened effect at the narrowed or width decreased central area where poling 14 has been carried out.

Since poling is not carried out for that part of the piezoelectric ceramic platelet 10 between the electrodes 11a and 11d, and that part between the electrodes 11b and 11c, these parts of the piezoelectric ceramic platelet function only as dielectric. Thereby, the parts of the ceramic platelet between the electrodes 11a and 11d and between the electrodes 11b and 11c function only as capacitances.

Therefore, an equivalent circuit of the ceramic resonator shown in Fig. 20A is as shown in Fig. 20B. The capacitor functioning between electrodes 11a and 11d corresponds to $C_e$ of Fig. 20B, whilst the capacitor functioning between the electrodes 11b and 11c corresponds to $C_e$ of Fig. 20B. The narrowed or width decreased area in the central portion where poling 14 has been carried out is equivalent to the parallel connection of a series circuit comprising La-Ra-Ca and Cb when the piezoelectric ceramic platelet 10 at the narrowed or width decreased central portion suffers width-extensional vibration.

The structure shown in Fig. 21A is formed by using a pair of ceramic resonators. Namely, the terminal 12bb of the ceramic resonator 1-7 and the equivalent terminal 12'bb (not shown) of the ceramic resonator 1-8 are connected by a line 41, and moreover the terminal 12bc of the ceramic resonator 1-7 and the equivalent terminal 12'bc (not shown) of the ceramic resonator 1-8 are connected, providing a terminal 42. When an AC electric field is applied across the terminals 12ad and 42, an equivalent circuit as indicated by $C_{c1}$, $L_{a1}$, $R_{a1}$, $C_{a1}$, $C_{b1}$, $C_{e1}$ shown in Fig. 21B is provided by the ceramic resonator 1-7, whilst an equivalent circuit indicated by $C_{e2}$, $L_{a2}$, $R_{a2}$, $C_{a2}$, $C_{b2}$, $C_{c2}$ is provided by the ceramic resonator 1-8.

Thus, the equivalent circuit shown in Fig. 21B is obtained by forming a ceramic filter as indicated in Fig. 21A. Thus, an equivalent circuit similar to that shown in Fig. 6A can be obtained. Here, in comparison with the equivalent circuit of Fig. 6A, $C_{s1}=C_{c1}$, $L_{m1}=L_{a1}$, $R_m=R_{a1}$, $C_{m1}=C_{a1}$, $C_{d1}=C_{b1}$, $Cc=C_{e1}+C_{e2}$, $L_{m2}=L_{a2}$, $R_{m2}=R_{a2}$, $C_{m2}=C_{a2}$, $C_{d2}=C_{b2}$, $C_{s2}=C_{c2}$.

As explained in detail, a ceramic filter embodying this invention can be formed of a pair of ceramic resonators, allowing structure to be simplified. Moreover, a lesser number of circuit elements and manufacturing steps required in relation to the ceramic resonators provides for considerable economy. In this case, the ceramic resonators may employ the basic structure shown in Fig. 7 or the structure shown in Fig. 13.

As explained above in detail, the resonant frequency of a ceramic filter using a ceramic resonator embodying the present invention is determined by the width W' of the narrowed or decreased width area and such a filter for operation in the frequency band from several hundreds kHz to several MHz can be made easily and moreover the resonators can be firmly held. Thereby a very economical and highly reliable ceramic resonator can be provided.

If flexure vibration occurs (depending on the conditions of the edges of a piezoelectric ceramic platelet), such flexure vibration can be suppressed by providing dumping materials 18a, 18b and spurious effects generated at a frequency near the width-extensional vibration frequency of the main vibration can also be suppressed. Restriction on the selection of sizes of piezoelectric ceramic platelets and on the selection of supporting means can be eased.

Such flexure vibration can also be suppressed by forming the narrowed or decreased width portion using symmetrical dents or indentations at the upper and lower sides of the central portion of a piezoelectric ceramic platelet in the longitudinal direction. Such a symmetrical structure supports normal longitudinal vibration only, without flexure vibration.

A ceramic resonator embodying this invention lends itself to mass-production and moreover allows fine adjustment with high accuracy. Thereby, small size and economical ceramic resonators can be realised.

A ceramic filter embodying this invention can offer improved frequency vs. loss characteristics using only width-extensional ceramic resonators of different thicknesses, and can raise significantly the S/N ratio of the filter output signals, bringing about high performance which has not been obtained previously with ceramic filters. Such a ceramic filter embodying this invention is effective in terms of improving performance, reducing size, and giving greater economy in a variety of communication systems. Particularly when a plurality of resonators are combined, the above advantages become more distinctive since a capacitance can be formed in the resonator itself through a combination of means involving definition of polarising or poling portion of the resonator and connecting methods used for the electrodes of the resonator.

A ceramic resonator or ceramic filter embodying this invention functions as a filter by itself even if only one unit is used, and a combination of a plurality of units, of course, functions very effectively. In all cases, it is to be understood that certain embodiments of the invention have been described but that this invention is not restricted thereto. It comprehends any combination of a variety of modifications and applications, as will be understood.

As described above in detail, a ceramic resonator embodying the present invention provides the effect that the vibration characteristic of the resonator is determined in accordance with the shape of the resonator.

In an embodiment of this invention it is required only to deposit electrode material on the entireties of the main surfaces through fine treatment on the piezoelectric ceramic platelet in comparison with a resonator associated with the prior art in which narrowed electrode portions are formed at the central part of the piezoelectric ceramic platelet formed only as a rectangular plate. Therefore, this invention avoids the need to consider the necessity of electrode patterning and the provision of masking for providing a desired electrode shape, thereby avoiding difficulties of alignment between piezoelectric ceramic platelet and the electrodes on its two sides.

**Claims**

1. A ceramic width-extensional mode resonator having a piezoelectric ceramic platelet (10, 20) with thickness direction poling, on opposite main surfaces of which platelet, separated by the thickness of the platelet, electrodes (11a to 11d; 21a to 21d) are formed, characterised in that the platelet has a portion, intermediate its opposite longitudinal ends, of a width ($W_1$) narrower than the width (W) at those opposite longitudinal ends, the opposite main surface parts of the platelet corresponding to the narrower width portion being entirely covered by electrodes (11a, 11b; 21a, 21b).

2. A ceramic resonator as claimed in claim 1, wherein metal thin film electrodes (11a to 11d; 21a to 21d) are foremd over substantially all of the main surfaces of the platelet (10, 20) on one main surface there being first (11a; 21a) and third (11c; 21c) electrodes which are separated longitudinally of the platelet by a division (13a; 23a) running the width of the platelet on the said one main surface, on the other main surface there being second (11b; 21b) and fourth (11d; 21d) electrodes which are separated longitudinally of the platelet by a division (13b; 23b) running the width of the platelet on the said other main surface, the respective divisions on the one and other main surfaces being at opposite longitudinal ends of the narrower width portion so that the narrower width portion is sandwiched between parts of the first (11a; 21a) and second (11b; 21b) electrodes.

3. A ceramic resonator as claimed in claim 1 or 2, wherein the narrower width portion is formed by an indentation in one of the surfaces of the platelet (10) which are separated by the width of the platelet.

4. A ceramic resonator as claimed in claim 1 or 2, wherein the narrower width portion is formed by indentations in both surfaces of the platelet (20) which are separated by the width of the platelet.

5. A ceramic resonator, as claimed in claim 1, 2, 3 or 4, poled in the thickness direction of the platelet (10, 20) over the entire longitudinal extent of the platelet.

6. A ceramic resonator as claimed in claim 1, 2, 3 or 4, poled in the thickness direction of the platelet (10, 20) only over the longitudinal extent of the narrower width portion of the platelet.

7. A ceramic resonator as claimed in claim 2 or any one of claims 3 to 5 read as appended to claim 2, wherein one or both of connections between the first electrode (11a; 21a) and the third electrode (11c; 21c) and between the second electrode (11b; 21b) and the fourth electrode (11d; 21d) is or are established.

8. A ceramic resonator as claimed in a preceding claim, wherein dumping material (18a, 18b) is provided on at least one of the surfaces of the platelet (10, 20) which are separated by the width of the platelet, towards a longitudinal end of the platelet, in order to suppress spurious effects.

9. A ceramic filter comprising plurality of ceramic resonators (1-5, 1-6; 1-7, 1-8) as claimed in any preceding claim connected in series.

10. A ceramic filter as claimed in claim 9, where the thickness (ta) of at least one of the resonators (1-5) is sbustantially different from the thickness (tb) of at least one other of the resonators (1-6).

11. A ceramic filter as claimed in claim 9 or 10, where a series connecting point between resonators (1-7, 1-8) of the plurality is a junction point of effective capacitors (Ce1, Ce2) connected in parallel.

12. A ceramic filter as claimed in claim 9, 10 or 11, wherein at least two of the resonators of the plurality are as claimed in claim 2, and wherein the second (11b; 21b) and third (11c; 21c) electrodes of those two resonators are respectively connected together; the thus established third electrode connecting point being considered as the common end; the fourth electrode (11d; 21d) of one resonator of those two being an input end; and the fourth electrode (11d; 21d) of the other resonator of those two being output end.

**Patentansprüche**

1. Keramischer Breitenausdehnungsmodus-Resonator mit einem piezoelectrischen keramischen Plättchen (10, 20) mit Dickenrichtungspolung, auf entgegenesetzten Hauptoberflächen des Plättchens, getrennt durch die Dicke des Plättchens, gebildeten Elektroden (11a, bis 11d; 21a bis 21d), dadurch gekennzeichzwischen seinen gegenüberliegenden Längsenden, dessen Breite (W₁) schmaler als die Längsenden, dessen Breite (W₁) schmaler als die Breite (W) an jenen gegenüberliegenden Längsenden ist, wobei die gegenüberliegenden Hauptoberflächenteile des Plättchens, die dem schmaleren Breitenabschnitt entsprechen, vollständig durch Elektroden (11a, 11b; 21a, 21b) bedeckt sind.

2. Keramischer Resonator nach Anspruch 1, bei dem metallene Dünnfilmelektroden (11a bis 11d; 21a bis 21d) über im wesentlichen allen Hauptoberflächen des Plättchens (10, 20) gebildet sind, auf einer Hauptoberfläche eine erste (11a; 21a) und dritte (11c; 21c) Elektroden sind, welche in Längsrichtung des Plättchens durch eine Teilung (13a; 23a), welche über die Breite des Plättchens auf der genannten einen Hauptoberfläche läuft, unterteilt sind, auf der anderen Hauptoberfläche einer zweite (11b; 21b) und vierte (11d; 21d) Elektrode sind, welche in Längsrichtung des Plättchens durch eine Unterteilung (13b; 23b), welche über die Breite des Plättchens auf der genannten anderen Hauptoberfläche läuft, getrennt sind, wobei die entsprechenden Unterteilungen auf der einen und der anderen Hauptoberfläche an gengenüberliegenden Längsenden des schmaleren Breitenabschnitts sind, so daß der schmalere Breitenabschnitt schichtartig zwischen Teilen der ersten (11a; 21a) und zweiten (11b; 21b) Elektrode angeordnet ist.

3. Keramischer Resonator nach Anspruch 1 oder 2, bei dem der schmalere Breitenabschnitt durch eine Vertiefung in einer der Oberflächen des Plättchens (10), welch durch die Breite des Plättchens getrennt sind, gebildet ist.

4. Keramischer Resonator nach Anspruch 1 oder 2, bei dem der schmalere Breitenabschnitt durch Vertiefungen in beiden Oberflächen des Plättchens (20), welche durch die Breite des Plättchens getrennt sind, gebildet ist. .

5. Keramischer Resonator nach Anspruch 1, 2, 3 oder 4, gepolt in der Dickenrichtung des Plättchens (10, 20) über der gesamten Längserstreckung des Plättchens.

6. Keramischer Resonator nach Anspruch 1, 2, 3 oder 4, gepolt in der Dickenrichtung des Plättchens (10, 20) lediglich über die Längserstreckung des schmaleren Breitenabschnitts des Plättchens.

7. Keramischer Resonator nach Anspruch 2 oder einem der Ansprüche 3 bis 5 in Verbindung mit Anspruch 2, bein dem eine oder beide Verbindungen zwischen der ersten Elektrode (11a; 21a) und der dritten Elektrode (11c; 21c) und zwischen der zweiten Elektrode (11b; 21b) und der vierten Elektrode (11d; 21d) hergestellt ist oder sind.

8. Keramischer Resonator nach einem der vorhergehenden Ansprüche, bei dem Ablagerungsmaterial (18a, 18b) auf wenigstens einer der Oberflächen des Plättchens (10, 20), welche durch die Breite des Plättchens getrennt sind, vorgesehen ist, zu einem Längsende des Plättchens hin, um Störeffekte zu unterdrücken.

9. Keramischer Filter mit einer Vielzahl von keramischen Resonatoren (1-5, 1-6; 1-7, 1-8) nach einem der vorhergehenden Ansprüche, in Reihe geschaltet.

10. Keramischer Filter nach Anspruch 9, bei dem die Dicke (ta) von wenigstens einem der Resonatoren (1-5) wesentlich unterschiedlich von der Dicke (tb) von wenigstens einem anderen der Resonatoren (1-6) ist.

11. Keramischer Filter nach Anspruch 9 oder 10, bei dem ein Reihenverbindungspunkt zwischen den Resonatoren (1-7, 1-8) der Vielzahl ein Verbindungspunkt von effektiven Kondensatoren (Ce1, Ce2) ist, die parallel verbunden sind.

12. Keramischer Filter nach Anspruch 9, 10 oder 11, bei dem wenigstens zwei der Resonatoren der Vielzahl so sind, wie in Anspruch 2 beansprucht, und bei dem die zweite (11b; 21b) und dritte (11c; 21c) Elektrode jener beiden Resonatoren jeweils zusammen verbunden sind; die so hergestellte dritte Elektrode einen Punkt, der als das gemeinsame Ende betrachtet wird, verbindet; die vierte Elektrode (11d; 21d) des einen Resonators von jenen beiden ein Eingangsende ist; und die vierte Elektrode (11d; 21d) des anderen Resonators von jenen beiden das Ausgangsende ist.

## Revendications

1. Résonateur en céramique en mode d'extension de largeur comprenant une plaquette de céramique piézoélectrique (10, 20) avec une polarisation dans la direction de l'épaisseur, sur les surfaces principales opposées de laquelle sont formées des électrodes (11a à 11d; 21a à 21d) séparées par l'épaisseur de la plaquette, caractérisé en ce que la plaquette comporte une partie entre ses extrémités longitudinales opposées, d'une largeur (W1) plus étroite que la largeur (W) aux extrémités longitudinales opposées, les parties de surfaces principales opposées de la plaquette correspondant à la partie de largeur réduite étant entièrement recouvertes par des électrodes (11a, 11b; 21a, 21b).

2. Résonateur en céramique selon la revendication 1, dans lequel des électrodes (11a à 11d; 21a à 21d) en minces pellicules métalliques sont formées sur pratiquement toutes les surfaces principales de la plaquette (10, 20), une première surface principale portant une première (11a; 21a) et une troisième (11c; 21c) électrodes qui sont séparées dans la direction longitudinale de la plaquette par une division (13a; 23a) se prolongeant sur la largeur de la plaquette sur ladite première surface principale, l'autre surface principale portant la seconde (11b; 21b) et la quatrième (11d; 21d) électrodes qui sont séparées dans la direction longitudinale de la plaquette par une division (13b; 23b) se prolongeant sur la largeur de la plaquette, sur ladite autre surface principale, les divisions respectives sur la première surface principale et sur l'autre étant aux extrémités longitudinales opposées de la partie de largeur réduite de manière que cette partie de largeur réduite soit intercalée entre des parties de la première (11a; 21a) et de la seconde (11b; 21b) électrodes.

3. Résonateur en céramique selon la revendication 1 ou 2, dans lequel la partie de largeur réduite est formée par une encoche dans l'une des surfaces de la plaquette (10) qui sont séparées par la largeur de la plaquette.

4. Résonateur en céramique selon la revendication 1 ou 2, dans lequel la partie de largeur réduite est formée par des encoches dans les deux surfaces de la plaquette (20) qui sont séparées par la largeur de la plaquette.

5. Résonateur en céramique selon la revendication 1, 2, 3 ou 4 polarisée dans la direction de l'épaisseur de la plaquette (10, 20) sur toute l'étendue longitudinale de la plaquette.

6. Résonateur en céramique selon la revendication 1, 2, 3 ou 4, polarisée dans la direction de l'épaisseur de la plaquette (10, 20) seulement dans l'étendue longitudinale de la partie de largeur réduite de la plaquette.

7. Résonateur en céramique selon la revendication 2 ou l'une quelconque des revendications 3 à 5 lues en dépendance de la revendication 2, dans lequel l'une ou les deux connexions entre la première électrode (11a; 21a) et la troisième électrode (11c; 21c) et entre la seconde électrode (11b; 21b) et la quatrième électrode (11d; 21d) est ou sont établies.

8. Résonateur en céramique selon l'une quelconque des revendications précédentes, dans lequel une matière d'amortissement (18a, 18b) est prévue sur l'une au moins des surfaces de la plaquette (10, 20) qui sont séparées par la largeur de la plaquette, vers une extrémité longitudinale de la plaquette afin de supprimer des effets parasites.

9. Filtre en céramique comprenant plusieurs résonateurs en céramique (1-5; 1-6; 1-7, 1-8) tels que revendiqués dans l'une quelconque des revendications précédentes, et connectés en série.

10. Filtre en céramique selon la revendication 9, dans lequel l'épaisseur (ta) de l'un au moins des résonateurs (1-5) est nettement différente de l'épaisseur (tb) d'au moins un autre des résonateurs (1-6).

11. Filtre en céramique selon la revendication 9 ou 10, dans lequel un point de connexion en série entre des résonateurs (1-7, 1-8) parmi les plusieurs résonateurs est un point de jonction de condensateurs effectifs (Ce1, Ce2) connectés en parallèle.

12. Filtre en céramique selon la revendication 9, 10 ou 11, dans lequel au moins deux des résonateurs parmi les plusieurs résonateurs sont tels que revendiqués dans la revendication 2 et dans lequel la seconde (11b; 21b) et la troisième (11c; 21c) électrodes de ces deux résonateurs sont connectées respectivement ensemble, le point de connexion de troisième électrode ainsi établi étant considéré comme l'extrémité commune; la quatrième électrode (11d; 21d) d'un résonateur parmi ces deux résonateurs étant une extrémité d'entrée; et la quatrième électrode (11d; 21d) de l'autre résonateur parmi les deux résonateurs étant l'extrémité de sortie.

Fig. 1 A

Fig. 1 B

Fig. 1 C

61
6
62'
62

61
6
62'
62
62
63'
63
64'
64
66

61
6
65'
65
66'

Fig. 2

72
7
73
71
74
73'
74'
72'
t

1

Fig. 3

Fig. 4

Fig. 5

Fig. 6A

Fig. 6B

0 083 237

Fig. 7

Fig. 8

Fig. 9

5

Fig. 10

Fig. 13

Fig. 11

Voltage

A

B

Frequency

Fig. 12

Voltage

Frequency

Fig. 14 A

1-4

12ad    11d    13b    14'    11b    10    12b

11a    13a    11C

Fig. 14 B

12ad    Lm    Cm    12b

Cs    Cd

Fig. 15

3

1-5    1-6

ta    tb

Fig. 16

Fig. 17

Fig. 18

Loss

Frequency

Fig. 19

Loss

Frequency

*Fig. 20A*

*Fig. 20B*

*Fig. 21A*

*Fig. 21B*